# EUROPEAN PATENT SPECIFICATION

(11) **EP 3 450 713 B1**
(45) Date of publication and mention of the grant of the patent: **17.02.2021**
(21) Application number: 16899914.2
(22) Date of filing: 09.05.2016
(51) Int. Cl.: F01N 5/02, F01N 3/04

(54) **PROCESS AND EQUIPMENT OF USING SEAWATER TO SCRUB AND CLEAN EXHAUST GAS OF ENGINE IN OCEAN ENGINEERING**
PROZESS UND VORRICHTUNG ZUR BENUTZUNG VON MEERWASSER ZUM WASCHEN UND REINIGEN DES ABGASES EINES MOTORS IN DER OZEANTECHNIK
PROCÉDÉ ET DISPOSITIF D'UTILISATION D'EAU DE MER POUR LAVAGE ET D'ÉPURATION DE GAZ D'ÉCHAPPEMENT DE MOTEUR DE GÉNIE OCÉANIQUE

(30) Priority: 26.04.2016 CN 201610263795
(43) Date of publication of application: 06.03.2019
(73) Proprietor: Peng, Sigan, Hubei 430072 (CN)
(72) Inventor: Peng, Sigan, Hubei 430072 (CN)
(74) Representative: Qip Patentanwälte Dr. Kuehn & Partner mbB
(86) International application number: PCT/CN2016/081401
(87) International publication number: WO 2017/185403

(56) References cited:
- EP-A2- 2 383 533
- WO-A1-2011/073503
- CN-A- 1 485 003
- CN-A- 102 852 596
- CN-A- 104 819 040
- CN-A- 104 826 475
- KR-B1- 101 532 042
- US-A1- 2007 144 500
- ANONYMOUS: "ABS Advisory on Exhaust Gas Scrubber Systems", STATUS AND GUIDANCE, ABS, US , 22 March 2013 (2013-03-22), pages 1-48, XP009505614, Retrieved from the Internet: URL:https://ww2.eagle.org/content/dam/eagl e/advisories-and-debriefs/ABS_Scrubber_Sys tems_Advisory_17125.pdf

## Description

### FIELD OF THE INVENTION

The present invention relates to a process and an equipment of using seawater to scrub and clean exhaust gas of engine in ocean engineering with zero energy consumption, which can be applied for the aftertreatment of exhaust gas discharged from motive facilities of ocean engineering such as marine ships and offshore platforms, and belongs to the technical field of ocean engineering and clean energy.

### DESCRIPTION OF RELATED ART

In recent years, there has been a conflict between the implementation of the low-sulphur decree of the Convention of United Nations for the Prevention of Atmosphere Pollution From Ships industry and the general requirement of improving energy efficiency and reducing carbon emissions in ocean shipping. More and more districts are required to implement the low-sulphur decree mandatorily. If low-sulphur fuel is used alternatively, the oil refining industry will have to increase a large number of carbon emissions due to the extract of a large number of low-sulphur fuels. If the Exhaust Gas Cleaning (EGC) technology is used to replace the low-sulfur fuel, although the total energy consumption is not large and the increment in carbon emissions is far less than one of fuel refining industry of low-sulfur fuel, the user will be concerned for the Energy Efficiency Design Index (EEDI) of ships because energy consumption of EGC for ships is a net increment. On the other hand, the unused thermal energy of exhaust gas of internal

combustion engine of a ship is about one third of all the thermal energy of fuels, but inefficient gas-solid heat transferring mode is generally adopted in existing heat recovery boilers of ships, which produces very little effect. It has been expected by people for a long-time to solve the problem on how to improve the heat recovery efficiency of exhaust gas.

WO 2011/073503 A1 discloses a scrubber unit arrangement for cleaning exhaust gas.

### SUMMARY OF THE INVENTION

The objects of the present invention is to overcome the disadvantage of low Energy Efficiency Design Index of ships due to the energy consumption of existing EGC technology, and to provide a process and an equipment of using seawater to scrub and clean exhaust gas of engine in ocean engineering with zero energy consumption for ocean engineering facilities such as marine ships and offshore platforms. In the present invention, the unused thermal energy is recycled at the same time that the exhaust gas of engine is scrubbed and cleaned, and the value of energy consumption of EGC is equivalent to near zero or even negative, so that the low-sulfur decree can be implemented on marine ships in a mode of low carbon and the Energy Efficiency Design Index of ships will not be lowered but even be improved.

The process of using seawater to scrub and clean exhaust gas of engine in ocean engineering with zero energy consumption of the present invention comprises the steps as below.

A process of using seawater to scrub and clean exhaust gas of engine in ocean engineering with zero energy consumption comprises steps of:
leading the exhaust gas of engine into a scrubbing tower of a scrubbing and cleaning system;
pumping seawater into the scrubbing tower with a seawater pump;
scrubbing the exhaust gas of engine with the seawater in the scrubbing tower; and
discharging clean exhaust gas and scrubbing seawater out of the scrubbing and cleaning system after scrubbing;
wherein a step of recycling thermal energy of the scrubbing seawater is carried out before the scrubbing seawater is discharged out of the scrubbing and cleaning system, and in the step of recycling thermal energy, the thermal energy of the scrubbing seawater is recycled and used as the power of the seawater pump.

Preferred embodiments are provided as below.

In the step that the thermal energy of the scrubbing seawater is recycled and used as the power of the seawater pump, the temperature difference between the scrubbing seawater and environmental seawater is utilized to generate the electric energy and the generated electric energy is used as the power of the seawater pump.

In the step of recycling thermal energy of the scrubbing seawater, the thermal energy is used for heating and/or refrigeration and/or seawater desalination, so that the load of original power system of marine facilities is reduced to save electric power, and the saved electric power is transmitted out through the power system of marine facilities and used as the power of the seawater pump.

In the step that the temperature difference is utilized to generate the electric energy and the generated electric energy is used as the power of the seawater pump, the electric quantity generated in the thermoelectric power generation is used to adjust the seawater flow of the seawater pump to realize a stable and constant-temperature self-run of the seawater scrubbing and cleaning system.

The technical solution of the equipment of using seawater to scrub and clean exhaust gas of engine in ocean engineering with zero energy consumption of the present invention is provided as below.

An equipment of using seawater to scrub and clean exhaust gas of engine in ocean engineering with zero energy consumption for carrying out the process of the present invention comprises: a scrubbing tower, a seawater pump, an unit of utilizing thermal energy and a electric controller, wherein a seawater outlet of the seawater pump is connected to a seawater inlet of the scrubbing tower, and a scrubbing-water outlet of the scrubbing tower is connected a scrubbing-water inlet of the unit of utilizing thermal energy, and a scrubbing-water discharging outlet of the unit of utilizing thermal energy is communicated with a water discharging outlet of a scrubbing device, and the unit of utilizing thermal energy is electrically connected to the electric controller, and the electric controller is electrically connected to the seawater pump.

The unit of utilizing thermal energy is a semiconductor thermoelectric power generator, and the electric controller is a switch controller, which is connected to a startup power source, and/or a controller, which is connected to the power system of marine facilities. Preferred embodiments are provided as below:
The seawater pump is a motor pump in which the flow is adjustable based on inputted electric power.

The unit of utilizing thermal energy is composed of a heating and heat preserving device for ship oil tank and/or a lithium bromide refrigerating device and/or a seawater desalination device, and the electric controller is a controller which is connected to the power system of marine facilities.

The technical principle and effects of the process and equipment of using seawater to scrub and clean exhaust gas of engine in ocean engineering with zero energy consumption of the present invention are set forth as below.

The gas-liquid-solid heat transferring mode is adopted to recycle the unused heat of the exhaust gas of engine in the present invention, that is, the heat of the exhaust gas enters into the scrubbing seawater, and then the heat of the scrubbing seawater is transferred to the heat recycling device, thus the heat recovery efficiency is high. In the present invention, the appropriate utilization mode of low-temperature heat source is adopted, and the results of high efficiency of reducing emissions and low energy consumption can be achieved in seawater scrubbing process. Therefore, in the present invention, the unused thermal energy can be recycled at the same time that the exhaust gas of engine is scrubbed and cleaned, so that the energy consumption of the EGC system of seawater scrubbing can be equivalent to nearly zero or even negative. So, the low-sulfur decree can be implemented on marine ships in a mode of low carbon and the Energy Efficiency Design Index of ships will not be lowered but even be improved. Therefore, the invention has remarkable technical effects.

### BRIEF DESCRIPTION OF THE DRAWINGS

Names of components or structures corresponding to the reference numbers in the drawings are provided as below.
Figure 1 is a schematic diagram showing an example of the process of using seawater to scrub and clean exhaust gas of engine in ocean engineering with zero energy consumption of the present invention.
Figure 2 is a schematic diagram showing an example of the equipment of using seawater to scrub and clean exhaust gas of engine in ocean engineering with zero energy consumption of the present invention.

In the drawings, 1-scrubbing tower, 2-seawater pump, 3-unit of utilizing thermal energy, 3.1- thermoelectric power generator, 3.2-heat exchanger, 4- electric controller, 5-engine of ocean engineering, 6-bottom gate for entering of seawater, 7-outlet for discharging clean exhaust gas, 8-scrubbing-seawater discharging outlet, 9-electric circuit for connecting unit of utilizing thermal energy and electric controller, 10-electric circuit for connecting electric controller and seawater pump, 11-ship's hold.

### DETAILED DESCRIPTION OF THE PRERERRED EMBODIMENTS

Combined with the figures and examples, the further description on the process and the equipment of using seawater to scrub and clean exhaust gas of engine in ocean engineering with zero energy consumption of the present invention is provided as below.

### Example 1

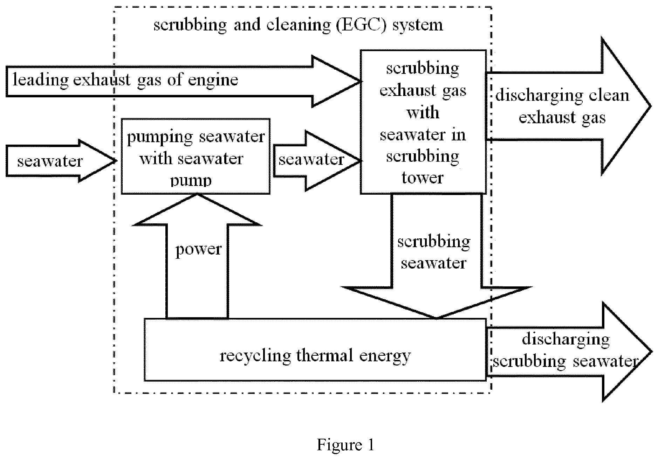

This is a basic example of the process of using seawater to scrub and clean exhaust gas of engine in ocean engineering with zero energy consumption of the present invention. As shown in Figure 1, the process comprises steps of:
leading the exhaust gas of engine into a scrubbing tower of a scrubbing and cleaning system;
pumping seawater into the scrubbing tower with a seawater pump;
scrubbing the exhaust gas of engine with the seawater in the scrubbing tower; and
discharging clean exhaust gas and scrubbing seawater out of the scrubbing and cleaning system after scrubbing;
wherein a step of recycling thermal energy of the scrubbing seawater is carried out before the scrubbing seawater is discharged out of the scrubbing and cleaning system, and in the step of recycling thermal energy, the thermal energy of the scrubbing seawater is recycled and used as the power of the seawater pump.

### Example 2

This is an example based on Example 1. In the step that the thermal energy of the scrubbing seawater is recycled and used as the power of the seawater pump, the temperature difference between the scrubbing seawater and environmental seawater is utilized to generate the electric energy and the generated electric energy is used as the power of the seawater pump.

In a further example, in the step that the temperature difference is utilized to generate the electric energy and the generated electric energy is used as the power of the seawater pump, the electric quantity generated in the thermoelectric power generation is used to adjust the seawater flow of the seawater pump to realize the stable and constant-temperature self-run of the seawater scrubbing and cleaning system.

### Example 3

This is another example based on Example 1. In the step of recycling thermal energy of the scrubbing seawater, the thermal energy is used for heating.

In another example, in the step of recycling thermal energy of the scrubbing seawater, the thermal energy is used for refrigeration.

In another example, in the step of recycling thermal energy of the scrubbing seawater, the thermal energy is used for seawater desalination.

In all of above examples, the load of original power system of marine facilities is reduced to save electric power, and the saved electric power is transmitted out through the power system of marine facilities and used as the power of the seawater pump. In this way, the purpose that the thermal energy of the scrubbing seawater is recycled and used as the power of the seawater pump can also be realized.

### Example 4

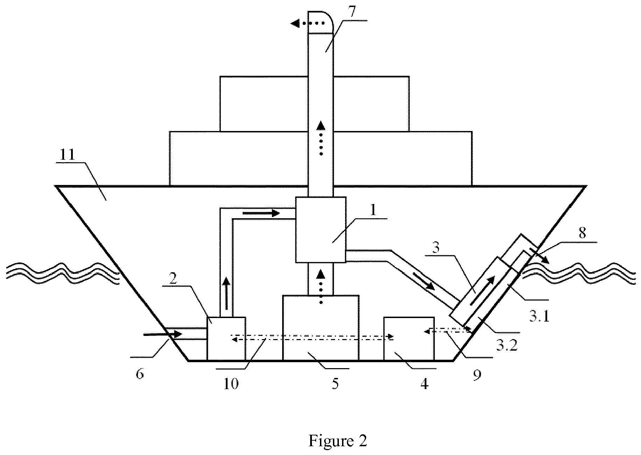

This is a basic example of the equipment of using seawater to scrub and clean exhaust gas of engine in ocean engineering with zero energy consumption for carrying out the process of using seawater to scrub and clean exhaust gas of engine in ocean engineering with zero energy consumption of the present invention. As shown in Figure 2, the equipment comprises a scrubbing tower 1, a seawater pump 2, an unit of utilizing thermal energy 3 and a electric controller 4, wherein a seawater outlet of the seawater pump 2 is connected to a seawater inlet of the scrubbing tower, and a scrubbing water outlet of the scrubbing tower 1 is connected a scrubbing water inlet of the unit of utilizing thermal energy 3, and a scrubbing-water discharging outlet of the unit of utilizing thermal energy 3 is communicated with a water discharging outlet of a scrubbing device, and the unit of utilizing thermal energy 3 is electrically connected to the electric controller 4, and the electric controller 4 is electrically connected to the seawater pump 2.

In a further example, the unit of utilizing thermal energy 3 comprises a thermoelectric power generator 3.1 and a heat exchanger 3.2. The exhaust gas discharged from engine of ocean engineering 5 is led into the scrubbing tower 1 and scrubbed and cleaned and then discharged out through an out let for discharging clean exhaust 7. The seawater is pumped into the scrubbing tower 1 by the seawater pump 2 to scrub the exhaust gas through a bottom gate for entering of seawater 6 of the ship. The hot scrubbing seawater, which heats up after scrubbing the exhaust gas, passes through the unit of utilizing thermal energy 3, and then is discharged out through the scrubbing-seawater discharging outlet 8. The unit of utilizing thermal energy 3 is electrically connected to the electric controller 4 through electric circuit 9. The electric controller 4 is electrically connected to the seawater pump 2 through electric circuit 10. The whole set of equipment using seawater for scrubbing and cleaning is installed in ship's hold 11.

### Example 5

This is a further example based on Example 4. The unit of utilizing thermal energy comprises a semiconductor thermoelectric power generator 3.1, and the electric controller 4 is a switch controller, which is connected to a startup power source. The semiconductor thermoelectric power generator 3.1 is composed of multigroup semiconductor thermoelectric power generating modules connected in series and in parallel. The number of combined generating modules is determined by matching the current and voltage generated under rated conditions with the rated power of the seawater pump. As shown in Figure 2, the hot side of the semiconductor thermoelectric power generator 3.1 is configured to fit the pipe of scrubbing water discharged from the scrubbing tower 1 in a way of thermal closeness, and the cold side of the semiconductor thermoelectric power generator 3.1 is configured to fit the steel plate of the ship in a way of thermal closeness, so that the temperature difference between the scrubbing seawater and environmental seawater can be utilized to generate the electric energy. The generated electric energy is used for driving the seawater pump 2 through the electric controller 4. The electric controller 4 is connected to a startup power source to realize the cold start of the EGC system. In another embodiment, the cold side of the semiconductor thermoelectric power generator 3.1 is configured to fit the seawater pipe in a way of thermal closeness.

In another example, the electric controller 4 is a controller which is connected to the power system of marine facilities, so that the electric energy generated from the thermoelectric power generator joins the power system of marine facilities through the electric controller, and then is used to drive the seawater pump through the controller of the power system of marine facilities.

In another example, the seawater pump 2 is a motor pump in which the flow is adjustable based on inputted electric power, so that the electric quantity generated in the thermoelectric power generation can be used to adjust the seawater flow of the seawater pump to form a negative feedback system. If the temperature of the scrubbing seawater rises, the electric power of thermoelectric power generation increases, and the flow of the seawater pump increases, and the increase of scrubbing seawater results in the reduction of temperature of the scrubbing seawater. In this way, the stable and constant-temperature self-run of the seawater scrubbing and cleaning system is realized.

### Example 6

This is a further example based on Example 4. The heat exchanger 3.2 included in the unit of utilizing thermal energy 3 provides heat source for the heating and heat preserving system for oil tank of ship.

In another example, the heat exchanger 3.2 included in the unit of utilizing thermal energy 3 provides heat source for the refrigerating system.

In another example, the heat exchanger 3.2 included in the unit of utilizing thermal energy 3 provides heat source for the seawater desalination system.

The electric controller 4 is a controller which is connected to the power system of marine facilities. In above examples, because the original heating system, refrigerating system and sweater desalination system of the ship use the thermal energy recycled from the scrubbing seawater, the load of original power system of marine facilities can be reduced to save electric power, and the saved electric power is transmitted out and used as the power of the seawater pump. In this way, the purpose that the thermal energy of the scrubbing seawater is recycled and used as the power of the seawater pump can be realized.

The protection scope of the claim of the present invention is not limited to the above examples.

## Claims

1. A process of using seawater to scrub and clean exhaust gas of engine in ocean engineering with zero energy consumption, comprising steps of:
leading the exhaust gas of engine into a scrubbing tower (1) of a scrubbing and cleaning system;
pumping seawater into the scrubbing tower (1) with a seawater pump (2);
scrubbing the exhaust gas of engine with the seawater in the scrubbing tower (1); and
discharging clean exhaust gas and scrubbing seawater out of the scrubbing and cleaning system after scrubbing;
**characterized in that**
a step of recycling thermal energy of the scrubbing seawater is carried out before the scrubbing seawater is discharged out of the scrubbing and cleaning system, and in the step of recycling thermal energy, the thermal energy of the scrubbing seawater is recycled and used as the power of the seawater pump, wherein in the step that the thermal energy of the scrubbing seawater is recycled and used as the power of the seawater pump, the temperature difference between the scrubbing seawater and environmental seawater is utilized to generate the electric energy and the generated electric energy is used as the power of the seawater pump.

2. The process of claim 1, wherein in the step that the temperature difference is utilized to generate the electric energy and the generated electric energy is used as the power of the seawater pump, the electric quantity generated in the thermoelectric power generation is used to adjust the seawater flow of the seawater pump to realize a stable and constant-temperature self-run of the seawater scrubbing and cleaning system.

3. An equipment of using seawater to scrub and clean exhaust gas of engine in ocean engineering with zero energy consumption for carrying out the process of claim 1, comprising: a scrubbing tower (1), a seawater pump (2), an unit of utilizing thermal energy (3) and a electric controller (4), wherein a seawater outlet of the seawater pump (2) is connected to a seawater inlet of the scrubbing tower, and a scrubbing-water outlet of the scrubbing tower (1) is connected a scrubbing-water inlet of the unit of utilizing thermal energy (3), and a scrubbing-water discharging outlet of the unit of utilizing thermal energy (3) is communicated with a water discharging outlet of a scrubbing device, and the unit of utilizing thermal energy (3) is electrically connected to the electric controller (4), and the electric controller (4) is electrically connected to the seawater pump (2), wherein the unit of utilizing thermal energy (3) is a semiconductor thermoelectric power generator, and the electric controller (4) is a switch controller, which is connected to a startup power source, and/or a controller, which is connected to the power system of marine facilities.

4. The equipment of claim 3, wherein the seawater pump (2) is a motor pump in which the flow is adjustable based on inputted electric power.

5. A marine ship, comprising the equipment according to any one of claims 3 and 4.

## Patentansprüche

1. Verfahren zur Verwendung von Meerwasser zum Waschen und Reinigen von Motorabgas in der Meerestechnik mit Null-Energieverbrauch, wobei das Verfahren folgende Schritte umfasst:
Leiten des Motorabgases in einen Waschturm (1) eines Wasch- und Reinigungssystems;
Pumpen von Meerwasser in den Waschturm (1) mit einer Meerwasserpumpe (2);
Waschen des Motorabgases mit dem Meerwasser in dem Waschturm (1); und
Ablassen von sauberem Abgas und Waschmeerwasser aus dem Wasch- und Reinigungssystem nach dem Waschen;
**dadurch gekennzeichnet, dass**
ein Schritt der Rückgewinnung von Wärmeenergie aus dem Waschmeerwasser durchgeführt wird, bevor das Waschmeerwasser aus dem Wasch- und Reinigungssystem abgelassen wird, und in dem Schritt der Rückgewinnung von Wärmeenergie die Wärmeenergie des Waschmeerwassers recycelt und als der Strom der Meerwasserpumpe genutzt wird, wobei in dem Schritt, in dem die Wärmeenergie des Waschmeerwassers recycelt und als der Strom der Meerwasserpumpe genutzt wird, die Temperaturdifferenz zwischen dem Waschmeerwasser und Umgebungsmeerwasser zur Erzeugung der elektrischen Energie verwendet wird und die erzeugte elektrische Energie als der Strom der Meerwasserpumpe verwendet wird.

2. Verfahren nach Anspruch 1, wobei in dem Schritt, in dem die Temperaturdifferenz zur Erzeugung der elektrischen Energie genutzt wird und die erzeugte elektrische Energie als der Strom der Meerwasserpumpe verwendet wird, die bei der thermoelektrischen Stromerzeugung erzeugte Elektrizitätsmenge dafür verwendet wird, den Meerwasserfluss der Meerwasserpumpe so einzustellen, dass ein stabiler und temperaturkonstanter Eigenlauf des Meerwasserwasch- und -reinigungssystems realisiert wird.

3. Vorrichtung zur Verwendung von Meerwasser zum Waschen und Reinigen von Motorabgas in der Meerestechnik mit Null-Energieverbrauch zur Durchführung des Verfahrens nach Anspruch 1, wobei die Vorrichtung umfasst: einen Waschturm (1), eine Meerwasserpumpe (2), eine Einheit zur Nutzung von Wärmeenergie (3) und einen elektrischen Controller (4), wobei ein Meerwasserauslass der Meerwasserpumpe (2) mit einem Meerwassereinlass des Waschturms verbunden ist und ein Waschwasserauslass des Waschturms (1) mit einem Waschwassereinlass der Einheit zur Nutzung von Wärmeenergie (3) verbunden ist und ein Waschwasserabgabeauslass der Einheit zur Nutzung von Wärmeenergie (3) mit einem Wasserabgabeauslass einer Waschvorrichtung verbunden ist und die Einheit zur Nutzung von Wärmeenergie (3) elektrisch mit dem elektrischen Controller (4) verbunden ist und der elektrische Controller (4) elektrisch mit der Meerwasserpumpe (2) verbunden ist, wobei die Einheit zur Nutzung von Wärmeenergie (3) ein thermoelektrischer Halbleiterstromgenerator ist und der elektrische Controller (4) eine Schalt-Controller ist, der mit einer Startstromquelle verbunden ist, und/oder ein Controller ist, der mit dem Stromversorgungssystem von Meereseinrichtungen verbunden ist.

4. Vorrichtung nach Anspruch 3, wobei die Meerwasserpumpe (2) eine Motorpumpe ist, deren Durchfluss auf der Grundlage zugeführter elektrischer Energie einstellbar ist.

5. Meeresfahrzeug, umfassend die Vorrichtung nach einem der Ansprüche 3 und 4.

## Revendications

1. Procédé d'utilisation de l'eau de mer pour laver et épurer des gaz d'échappement de moteur de génie océanique avec une consommation d'énergie nulle, comprenant les étapes consistant à :
diriger les gaz d'échappement de moteur vers une tour de lavage (1) de système de lavage et d'épuration ;
pomper de l'eau de mer dans la tour de lavage (1) à l'aide d'une pompe à eau de mer (2) ;
laver les gaz d'échappement de moteur avec l'eau de mer dans la tour de lavage (1) ; et
évacuer les gaz d'échappement propres et l'eau de mer de lavage hors du système de lavage et d'épuration après le lavage ;
**caractérisé en ce que** :
une étape de recyclage d'énergie thermique de l'eau de mer de lavage est réalisée avant que l'eau de mer de lavage ne soit évacuée hors du système de lavage et d'épuration, et à l'étape de recyclage d'énergie thermique, l'énergie thermique de l'eau de mer de lavage est recyclée et utilisée comme énergie de la pompe à eau de mer, dans lequel à l'étape où l'énergie thermique de l'eau de mer de lavage est recyclée et utilisée comme énergie de la pompe à eau de mer, la différence de température entre l'eau de mer de lavage et l'eau de mer de l'environnement est utilisée pour produire l'énergie électrique et l'énergie électrique produite est utilisée comme énergie de la pompe à eau de mer.

2. Procédé selon la revendication 1, dans lequel à l'étape où la différence de température est utilisée pour produire l'énergie électrique et où l'énergie électrique produite est utilisée comme énergie de la pompe à eau de mer, la grandeur électrique produite lors de la production d'énergie thermoélectrique est utilisée pour régler le débit d'eau de mer de la pompe à eau de mer afin d'obtenir un fonctionnement autonome stable et à température constante du système de lavage et d'épuration à l'eau de mer.

3. Équipement d'utilisation de l'eau de mer pour laver et épurer des gaz d'échappement de moteur de génie océanique avec une consommation d'énergie nulle, destiné à mettre en œuvre le procédé selon la revendication 1, comprenant : une tour de lavage (1), une pompe à eau de mer (2), une unité d'utilisation d'énergie thermique (3) et une unité de commande électrique (4), dans lequel une sortie d'eau de mer de la pompe à eau de mer (2) est raccordée à une entrée d'eau de mer de la tour de lavage, et une sortie d'eau de lavage de la tour de lavage (1) est raccordée à une entrée d'eau de lavage de l'unité d'utilisation d'énergie thermique (3), et une sortie d'évacuation d'eau de lavage de l'unité d'utilisation d'énergie thermique (3) communique avec une sortie d'évacuation d'eau d'un dispositif de lavage, et l'unité d'utilisation d'énergie thermique (3) est électriquement connectée à l'unité de commande électrique (4), et l'unité de commande électrique (4) est électriquement connectée à la pompe à eau de mer (2), dans lequel l'unité d'utilisation d'énergie thermique (3) est un générateur d'énergie thermoélectrique à semi-conducteur, et l'unité de commande électrique (4) est une unité de commande de commutation qui est connectée à une source d'énergie de démarrage, et/ou une unité de commande qui est connectée au réseau d'énergie d'installations maritimes.

4. Équipement selon la revendication 3, dans lequel la pompe à eau de mer (2) est une pompe moteur dans laquelle le débit est réglable en fonction de l'énergie électrique appliquée.

5. Navire marin comprenant l'équipement selon l'une quelconque des revendications 3 et 4.
